# EUROPÄISCHE PATENTANMELDUNG

(11) **EP 1 462 914 A2**
(43) Veröffentlichungstag der Anmeldung: **29.09.2004**
(21) Anmeldenummer: 04005334.0
(22) Anmeldetag: 05.03.2004
(51) Int. Cl.: G06F 1/18

(54) **Aufnahme für einen Flashspeicher**

(30) Priorität: 28.03.2003 DE 10314155
(71) Anmelder: Fujitsu Siemens Computers GmbH, 80807 München (DE)
(72) Erfinder: Kappler, Klaus, 81243 München (DE); Zetzmann, Harald, 86459 Gessertshausen (DE)
(74) Vertreter: Epping, Hermann, Fischer

(57) **Zusammenfassung**

Die Erfindung betrifft eine Aufnahme für einen Flashspeicher (1), der in einen Einbauschacht für eine Standardcomputerkomponente integriert ist, wobei der Flashspeicher (1) auf einen Träger (2) angeordnet ist, der in einen Einbaukäfig für Computerkomponenten festlegbar ist.

## Beschreibung

Die Erfindung betrifft eine Aufnahme für einen Flashspeicher.

Flashspeicher sind bekannt als Memory-Karten, Memory-Sticks oder als Disks On Module (DOMs). Flashspeicher werden in der Regel dann verwendet, wenn schnell von einem mobilen Gerät Daten auf den Computer übertragen werden sollen. Bisher erfolgt die Übertragung der Daten von einem Flashspeicher zu einem Computer mit Hilfe eines Kabels. Der Flashspeicher wird hierzu in ein Lesegerät eingesteckt, welches über Kabel mit dem Computer verbunden wird. Meist wird hierzu die USB-Schnittstelle verwendet.

Bei der Verwendung von externen Kabeln ist jedoch nachteilig, daß meist eine langsame Verbindung zu dem Computer besteht. Bei den immer größer werden Speicherkapazitäten kann eine Übertragung aller Daten mehrere Minuten beanspruchen.

Des weiteren ist auch die Handhabung umständlich, da der Kartenleser über ein Kabel am Computer angeschlossen sein muß. Insbesondere bei Computern, die nur auf der Rückseite eine entsprechende Schnittstelle aufweisen, ist das wiederholte Anschließen des Kabels für den Benutzer unangenehm. Bei ständig angeschlossenem Kartenleser hingegen besteht der Nachteil, daß der Arbeitsplatz mit immer mehr Geräten, wie Bildschirm, Maus, Tastatur, Telefon, Diktiergerät, PDA und eventuell noch weiteren Geräten versehen ist und dadurch die eigentliche Arbeitsfläche auf dem Schreibtisch immer kleiner wird.

Der Erfindung liegt daher die Aufgabe zugrunde, eine einfache kostengünstige Aufnahme für einen Flashspeicher zu entwickeln, die im Computergehäuse integriert ist.

Diese Aufgabe wird erfindungsgemäß dadurch gelöst, dass die Aufnahme auf einem Träger angeordnet ist, der in einem Einbaukäfig für Standardcomputerlaufwerke festlegbar ist, wobei der Träger Seitenteile mit Aufnahmelöchern im Maß der Gewindebohrungen bei Standardcomputerkomponenten aufweist.

Dadurch daß ein Flashspeicher auf einem Träger angeordnet ist, der in einem Einbaukäfig einer Computerkomponente, bevorzugt in einem für 5 1/4 Zoll-Laufwerke, festlegbar ist, ist vorteilhafterweise kein Kabel außerhalb des Computergehäuses zur Übertragung von Daten vom Flashspeicher zum Computer notwendig.

Der Flashspeicher ist vorzugsweise auf einem flächigen Träger angeordnet, der Seitenteile aufweist, die mit Aufnahmelöchern in der Größe von Gewindebohrungen einer Standardcomputerkomponente versehen sind. Über die Aufnahmelöcher kann der Träger im Einbauschacht für eine Standardcomputerkomponente festgelegt werden.

Der Träger kann flächig oder als Rahmenkonstruktion ausgebildet sein und aus unterschiedlichen Stoffen wie Metall oder Kunststoff bestehen.

Gemäß einer weiteren Ausgestaltung ist der Träger über Halteschienen im Einbaukäfig festlegbar.

Der Flashspeicher kann als Flashkarte oder Disk On Module (DOM) oder Disk On Chip (DOC) ausgeführt sein. Die Aufnahme kann auch für mehrere Flashspeicher, die parallel eingesteckt werden, ausgebildet sein.

Weitere Einzelheiten und Ausgestaltungen sind in den Unteransprüchen angegeben.

Die Erfindung wird nachfolgend anhand in den Zeichnungen dargestellter Ausführungsbeispiele näher erläutert.

In den Zeichnungen zeigen:
- Figur 1: eine erfindungsgemäße Flashspeicheraufnahme mit flächig ausgebildetem Träger
- Figur 2: eine Flashspeicheraufnahme nach Figur 1 mit Rahmenkonstruktion statt des flächig ausgebildeten Trägers
- Figur 3: eine Flashspeicheraufnahme nach Figur 1 mit parallel angeordneten Flashspeichern.

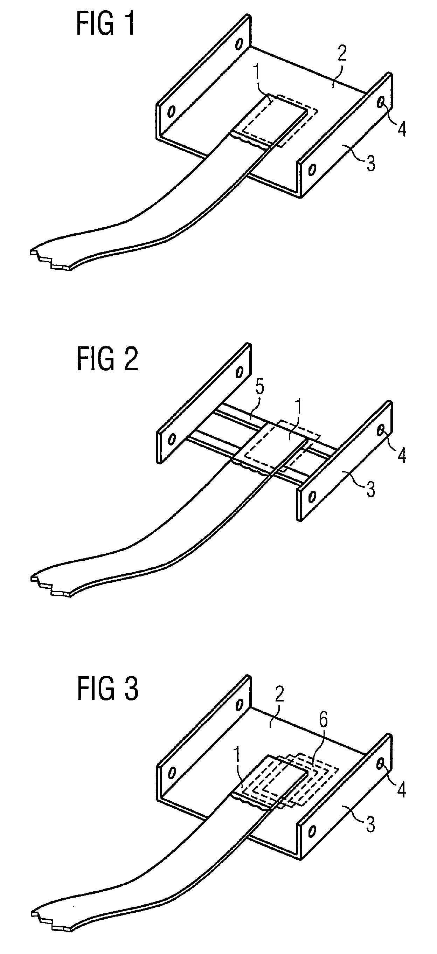

Figur 1 zeigt eine Ansicht von schräg oben auf eine Aufnahme für einen Flashspeicher 1, der auf einem flächig ausgebildeten Träger 2 angebracht ist. An dem Träger 2 sind auf zwei Seiten jeweils Seitenteile 3 angebracht, die Aufnahmelöcher 4 aufweisen, die in ihrem Maß und ihrer Größe den Gewindebohrungen einer Standardcomputerkomponente entsprechen. Über die Aufnahmelöcher kann die Aufnahme im Einbauschacht für eine Standardcomputerkomponente verschraubt werden.

Figur 2 zeigt eine Aufnahme für einen Flashspeicher 1, der auf einer Rahmenkonstruktion 5 angebracht ist. Diese ersetzt den flächig ausgebildeten Träger 2. An der Rahmenkonstruktion 5 sind an zwei Seiten wiederum jeweils Seitenteile 3 mit Aufnahmelöchern 4, die in Maß und Größe der Gewindebohrung einer Standardcomputerkomponente entsprechen, angebracht. Mit ihrer Hilfe kann die Aufnahme wiederum im Einbauschacht der Standardcomputerkomponente angebracht werden.

Die Aufnahmelöcher 4 sind ebenso mit einer Gewindebohrung versehen, so daß eine einfache Festlegung über Schrauben erfolgen kann.

Je nach Ausbildung des Einbaukäfigs im Computer können in die Aufnahmelöcher 4 auch Halteschienen (Easy-Change) gesteckt und die Aufnahme über die Halteschienen im Einbaukäfig festgelegt werden.

Figur 3 zeigt eine Aufnahme für einen Flashspeicher 1 nach Figur 1, der auf einem flächig ausgebildeten Träger 2 angebracht ist, wobei mehrere Flashspeicher 6 parallel in den Träger gesteckt sind.

### Bezugszeichenliste

- 1: Flashspeicher
- 2: Träger
- 3: Seitenteile
- 4: Aufnahmelöcher
- 5: Rahmenkonstruktion
- 6: mehrere parallel eingesteckte Flashspeicher

## Patentansprüche

1. Aufnahme für einen Flashspeicher (1),
**dadurch gekennzeichnet, dass**
sie auf einem Träger (2) angeordnet ist, der in einem Einbaukäfig für Computerkomponenten festlegbar ist, wobei der Träger (2) Seitenteile (3) mit Aufnahmelöchern (4) im Maß von Gewindebohrungen bei Standardcomputerkomponenten aufweist.

2. Aufnahme für einen Flashspeicher (1) nach Anspruch 1,
**dadurch gekennzeichnet, dass**
in die Aufnahmelöcher(4) Halteschienen eingesteckt sind und der Träger (2) über die Halteschienen im Einbaukäfig festlegbar ist.

3. Aufnahme für einen Flashspeicher (1) nach einem der Ansprüche 1 bis 2,
**dadurch gekennzeichnet, dass**
der Träger (2) flächig ausgebildet ist.

4. Aufnahme für einen Flashspeicher (1) nach einem der Ansprüche 1 bis 3 ,
**dadurch gekennzeichnet, dass**
der Träger(2) als Rahmenkonstruktion (5) ausgebildet ist.

5. Aufnahme für einen Flashspeicher (1) nach einem der Ansprüche 1 bis 4,
**dadurch gekennzeichnet, dass**
der Träger(2) aus Aluminium, Eisen oder Kunststoff hergestellt ist.

6. Aufnahme für einen Flashspeicher (1) nach einem der Ansprüche 1 bis 5,
**dadurch gekennzeichnet, dass**
der Flashspeicher (1) eine Flashkarte oder ein Disk On Module (DOM) oder ein Disk On Chip (DOC)ist.

7. Aufnahme für einen Flashspeicher (1) ) nach einem der Ansprüche 1 bis 6,
**dadurch gekennzeichnet, dass**
in die Aufnahme mehrere Flashspeicher (1) parallel einsteckbar sind (6).
